(19) **Europäisches Patentamt / European Patent Office / Office européen des brevets**

(11) **EP 2 817 644 B1**

(12) **FASCICULE DE BREVET EUROPEEN**

(45) Date de publication et mention de la délivrance du brevet:
**03.04.2019 Bulletin 2019/14**

(21) Numéro de dépôt: **13710469.1**

(22) Date de dépôt: **15.02.2013**

(51) Int Cl.:
**G01R 31/02** *(2006.01)*   **G01R 27/02** *(2006.01)*

(86) Numéro de dépôt international:
**PCT/FR2013/050320**

(87) Numéro de publication internationale:
**WO 2013/124571 (29.08.2013 Gazette 2013/35)**

(54) **PROCÉDÉ ET SYSTÈME D'ESTIMATION DE LA RÉSISTANCE D'ISOLEMENT ENTRE UNE BATTERIE ET UNE MASSE ÉLECTRIQUE**

VERFAHREN UND SYSTEM ZUR SCHÄTZUNG DES ISOLATIONSWIDERSTANDES ZWISCHEN EINER BATTERIE UND EINER ELEKTRISCHEN ERDUNG

METHOD AND SYSTEM FOR ESTIMATING THE INSULATION RESISTANCE BETWEEN A BATTERY AND AN ELECTRICAL EARTH

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.02.2012 FR 1251591**

(43) Date de publication de la demande:
**31.12.2014 Bulletin 2015/01**

(73) Titulaire: **Renault S.A.S.**
**92100 Boulogne-Billancourt (FR)**

(72) Inventeurs:
• **CORDESSES, Lionel**
  **F-78180 Montigny-le-Bretonneux (FR)**

• **MENSLER, Michel**
  **F-78180 Montigny-le-Bretonneux (FR)**
• **RANDI, Sid-Ali**
  **F-73000 Chambery (FR)**
• **CHATROUX, Daniel**
  **F-38470 Teche (FR)**
• **CARCOUET, Sébastien**
  **F-38450 Vif (FR)**

(56) Documents cités:
| | |
|---|---|
| US-A- 5 365 179 | US-A- 5 365 179 |
| US-A- 5 382 946 | US-A- 5 382 946 |
| US-A1- 2004 130 326 | US-A1- 2004 130 326 |
| US-A1- 2007 008 666 | US-A1- 2007 008 666 |

**EP 2 817 644 B1**

**Description**

L'invention a pour domaine technique la mesure de dipôles électriques et plus particulièrement la mesure de la résistance d'isolement au sein par exemple d'un véhicule comprenant une batterie à haute tension.

Dans un véhicule électrique ou hybride électrique comprenant une batterie à haute tension, la résistance d'isolement entre un point de la batterie lié à la haute tension (par exemple : la borne positive ou négative de la batterie ou un connecteur entre les cellules de la batterie, ou encore un bus haute tension) et la masse électrique du véhicule est un composant de sécurité indispensable. En effet, c'est la résistance d'isolement qui permet de prévenir tout choc électrique des passagers du véhicule ou des êtres vivants entrant en contact avec le véhicule.

Il est indispensable de mesurer cette résistance pour détecter puis corriger tout défaut d'isolement avant qu'un deuxième défaut d'isolement ne survienne. Un double défaut peut créer en effet un court-circuit. Plus généralement, un double défaut peut être dangereux si une personne touche la caisse du véhicule, même s'il n'y a pas de court circuit. Par exemple, dans le cas où la borne positive est reliée à la caisse et la borne négative est reliée à la terre, l'utilisateur avec les pieds à la terre qui touche la caisse est alors en contact direct avec les deux bornes positive et négative de la batterie.

Il est connu de l'état de la technique, l'utilisation d'un circuit de mesure branché sur une ou deux bornes de la batterie. Il est alors prévu de réaliser des mesures à différents endroits du circuit de mesure, ce qui rend la mesure complexe.

Il est également connu de l'état de la technique, l'utilisation d'un circuit de mesure comprenant une capacité de couplage. Il est alors prévu de mesurer la résistance d'isolement à partir de la valeur de capacité de couplage supposée connue.

Par exemple, la demande de brevet JP2003-250201 propose un circuit de mesure de la résistance d'isolement. Le circuit de mesure comprend une capacité dont la valeur est supposée connue pour réaliser la mesure de la résistance d'isolement. Cela étant, les capacités ordinaires ont en général une valeur qui varie en fonction de la température, de la tension à leurs bornes ou de leur vieillissement. Pour que cette supposition soit fondée et que la mesure soit fiable, il est donc nécessaire d'utiliser une capacité stable en valeur tout au long de son vieillissement. Cela implique en général un surcoût par rapport à une capacité ordinaire.

Le document US 2004/130326 divulgue un système d'estimation de la résistance d'isolement entre une borne d'une batterie et une masse électrique.

Il apparait donc que les techniques de mesure existantes ne sont pas fiables, sont complexes ou impliquent un surcoût.

Un but de l'invention est donc de proposer une méthode de mesure de la résistance d'isolement visant à résoudre les défauts mentionnés ci-dessus.

Il est proposé selon un mode de réalisation et de mise en oeuvre de l'invention, une méthode de mesure simple ne nécessitant qu'un seul point de mesure.

L'invention a donc pour objet un procédé d'estimation de la résistance d'isolement entre une borne d'une batterie et une masse électrique, comprenant :

- un branchement d'une borne de sortie d'un circuit de mesure à une borne de la batterie, ledit circuit de mesure comprenant une résistance de valeur connue et une capacité; et
- une application d'un signal d'entrée connu ayant une tension d'entrée à une borne d'entrée du circuit de mesure.

Selon une caractéristique générale, le procédé comprend en outre :

- une mesure d'une tension de sortie entre la masse et un point situé entre la résistance de valeur connue et la capacité;
- une détermination d'une impédance complexe d'un dipôle composé de la capacité et de la résistance d'isolement ou une détermination des paramètres d'une équation différentielle reliant la tension de sortie et la tension d'entrée; et
- une détermination de la résistance d'isolement à partir des paramètres de l'équation différentielle ou de ladite impédance complexe.

Il est ainsi possible de mesurer la résistance d'isolement avec un seul point de mesure, sans supposer connaître la valeur de la capacité du circuit de mesure. Cela est avantageux car cela permet avec une capacité ordinaire d'obtenir une mesure simple et fiable.

Selon une caractéristique, on détermine également la capacité du circuit de mesure à partir des paramètres de l'équation différentielle ou de ladite impédance complexe.

Selon une autre caractéristique, le signal d'entrée appliqué est un signal carré.

Le signal carré a pour avantage d'être facile à générer et de contenir de nombreuses harmoniques dont les amplitudes relatives sont connues.

Selon un mode de mise en oeuvre, la détermination des paramètres de l'équation différentielle comprend:

- un filtrage par un filtre linéaire de premier ordre de l'équation différentielle pour obtenir une deuxième équation reliant la tension d'entrée filtrée et la tension de sortie filtrée ;
- une détermination à partir de la tension d'entrée, de la tension d'entrée filtrée ;
- une détermination à partir de la tension de sortie, de la tension de sortie filtrée ; et
- une détermination des paramètres de ladite deuxième équation, lesdits paramètres de la deuxième équation étant égaux aux paramètres de l'équation différentielle.

L'utilisation d'un filtrage permet de s'affranchir du problème de calcul des dérivées de la tension d'entrée et de la tension de sortie de l'équation différentielle. En effet, ces tensions d'entrée et de sortie sont bruitées, ce qui rend difficile le calcul de leur dérivée.

Selon une caractéristique de ce mode de mise en oeuvre, ladite mesure de la tension de sortie est réalisée à plusieurs instants et la détermination des paramètres de ladite deuxième équation utilise une méthode des moindres carrés avec les valeurs auxdits plusieurs instants de la tension de sortie mesurée et de la tension d'entrée.

Il est ainsi possible, selon une méthode simple, de déterminer à partir de la deuxième équation, les paramètres de l'équation différentielle. On pourra alors en déduire les valeurs de la résistance d'isolement et de la capacité du circuit du circuit de mesure.

Selon un autre mode de mise en oeuvre, le procédé comprend en outre une analyse fréquentielle de la tension de sortie mesurée à au moins une fréquence de manière à déterminer pour au moins cette fréquence la valeur de l'impédance complexe, ladite application d'un signal d'entrée à la borne d'entrée du circuit de mesure, ladite mesure de la tension de sortie, ladite analyse fréquentielle et ladite détermination de la valeur de l'impédance complexe étant réalisées par un analyseur de réseau.

Les fonctionnalités de l'analyseur de réseau peuvent être réduites puisqu'il est suffisant de caractériser une impédance complexe en transmission, sur une plage de fréquence réduite et avec une précision de mesure de l'ordre de la dizaine de pourcents.

Selon une caractéristique de ce mode de mise en oeuvre, le procédé comprend en outre une numérisation de la tension de sortie mesurée et l'analyse fréquentielle est réalisée au moyen d'une transformée de Fourier ou d'un filtrage de Goertzel de la tension de sortie numérisée.

L'analyse fréquentiel peut alors être réalisée selon une méthode classique utilisant la transformée de Fourier. Avantageusement, l'analyse fréquentielle peut utiliser un filtrage de Goertzel. Le filtrage de Goertzel est plus rapide que la transformée de Fourier puisqu'il ne nécessite pas de calculer l'ensemble du spectre mais se limite au calcul d'une raie du spectre de la transformée de Fourier.

Selon une caractéristique, l'analyse fréquentielle est effectuée à une fréquence fondamentale de la tension d'entrée et/ou à deux harmoniques de la tension d'entrée.

Il est alors possible de déterminer pour la fréquence fondamentale et pour chacune des deux harmoniques une résistance d'isolement. Une triple détermination permet de choisir la bonne mesure parmi les trois, par un système de vote par exemple. Elle permet aussi de rejeter les mesures s'il y a une dispersion trop importante entre les trois déterminations.

L'invention a également pour objet un système d'estimation de la résistance d'isolement entre une borne d'une batterie et une masse électrique, comprenant un circuit de mesure qui comprend une borne de sortie, une borne d'entrée, une résistance de valeur connue et une capacité, la borne de sortie étant branchée à une borne de la batterie et la borne d'entrée étant destinée à recevoir un signal d'entrée connu ayant une tension d'entrée.

Selon une caractéristique générale, le système comprend en outre :

- un moyen de mesure d'une tension de sortie entre la masse et un point situé entre la résistance de valeur connue et la capacité;
- un moyen de détermination d'une impédance complexe d'un dipôle composé de la capacité et de la résistance d'isolement ou de paramètres d'une équation différentielle reliant la tension de sortie et la tension d'entrée; et
- un moyen de détermination de la résistance d'isolement à partir des paramètres de l'équation différentielle ou de ladite impédance complexe.

D'autres buts, caractéristiques et avantages apparaîtront à la lecture de la description suivante donnée uniquement en tant qu'exemple non limitatif et faite en référence aux dessins annexés sur lesquels :

- la figure 1 illustre un schéma de principe d'un circuit de mesure selon un mode de réalisation de l'invention;
- la figure 2 illustre un procédé de mesure selon un premier mode de mise en oeuvre de l'invention; et
- la figure 3 illustre un procédé de mesure selon un deuxième mode de mise en oeuvre de l'invention.

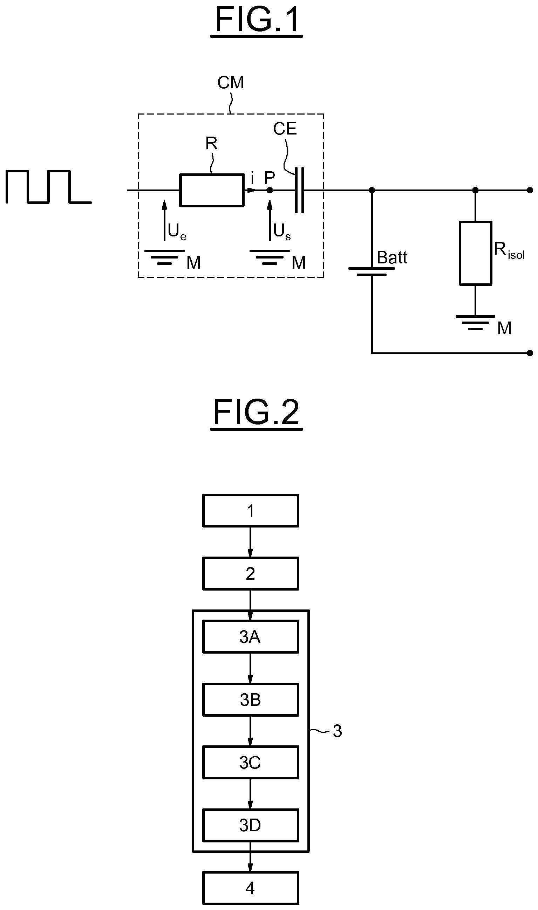

Sur la figure 1, est représenté un circuit de mesure CM comprenant une résistance R et une capacité CE, branché sur une borne d'une batterie haute tension Batt équipant un véhicule électrique. La batterie Batt est par exemple, une batterie de propulsion ou de traction du véhicule électrique.

A l'aide du circuit de mesure CM, on peut alors déterminer une résistance d'isolement Risol. La résistance Risol est la résistance entre une borne ou tout autre point de la batterie Batt et la masse électrique M du véhicule.

Le circuit de mesure CM comprend une borne d'entrée destinée à recevoir une tension d'entrée Ue et une borne de sortie branchée sur une des bornes de la batterie Batt. La résistance R du circuit de mesure CM est de valeur connue et la capacité de couplage CE du circuit de mesure est d'une valeur qui va être déterminée.

Pour la détermination de la capacité CE d'une part et la détermination de la résistance Risol entre la borne sur laquelle est branché le circuit CM et la masse d'autre part, on va mesurer une tension de sortie Us aux bornes d'un dipôle comprenant la capacité CE en série avec la résistance Risol. Pour cela, on va mesurer la tension entre un point P et la masse électrique M, ledit point P étant situé entre la résistance R et la capacité CE.

Sur la figure 2, est représenté selon un premier mode de mise en oeuvre, un procédé de mesure permettant de mesurer la tension de sortie et d'en déduire les valeurs de Risol et CE. Le procédé comprend :

- une première étape (étape 1) d'application d'un signal d'entrée dont l'amplitude et la fréquence sont connues, à la borne d'entrée du circuit de mesure CM. Par exemple le signal d'entrée est une tension Ue carrée de fréquence 0.5 Hz prenant comme valeur haute 5 volts et comme valeur basse 0 volt.
- une deuxième étape de mesure (étape 2) de la tension de sortie Us ;
- une troisième étape (étape 3) de détermination de paramètres d'une équation différentielle entre la tension d'entrée Ue et la tension de sortie Us. On obtient cette équation différentielle à partir d'une fonction de transfert, par exemple.

Pour cela, on applique la relation d'un diviseur de tension au montage comprenant en série la résistance R, la capacité de couplage CE et la résistance d'isolement Risol. On obtient alors la fonction de transfert suivante:

$$\frac{U_s}{U_e} = \frac{1 + R_{isol} \cdot CE \cdot s}{1 + CE \cdot (R_{isol} + R) \cdot s}$$

dans laquelle s est la variable de Laplace.

Puis on en déduit de cette fonction de transfert, l'équation différentielle correspondante. Il s'agit de la relation suivante :

$$a_0 \cdot u_s(t) + \dot{u}_s(t) = b_0 \cdot u_e(t) + b_1 \cdot \dot{u}_e(t) \qquad (\text{Equation 1}),$$

avec le changement de variables suivant :

$$\begin{cases} R_{isol} \cdot CE = \dfrac{b_1}{a_0} \\ CE \cdot (R_{isol} + R) = \dfrac{1}{a_0} \end{cases}$$

$$\begin{cases} R_{isol} = R \cdot \dfrac{b_1}{1 - b_1} \\ CE = \dfrac{1}{R} \cdot \dfrac{1 - b_1}{a_0} \end{cases}$$

On va alors utiliser cette première équation (Equation 1) pour déterminer les paramètres $a_0$, $b_0$ et $b_1$.

Pour cela, on applique à l'équation 1, la méthode dite des PMF ("Poisson Moment Functional") selon un acronyme anglo-saxon bien connu de l'homme du métier signifiant Fonctionnelles des Moments de Poisson. Pour cela, l'étape 3 du procédé comprend:

- une étape de filtrage (étape 3A) de l'équation différentielle (équation 1) par un filtre F1 du premier ordre de la forme :

$$\varphi(s) = \frac{\lambda}{s + \lambda} \, ,$$

dans laquelle le paramètre $\lambda$ est un paramètre de réglage de la méthode des PMF. Il peut par exemple être fixé en fonction de la valeur de la bande passante du système à identifier.

On obtient alors :

$$a_0 \, F_1\{u_s(t)\} + F_1\{\dot{u}_s(t)\} = b_0 \, F_1\{u_e(t)\} + b_1 \, F_1\{\dot{u}_e(t)\} \qquad (Equation\ 2),$$

dans laquelle $F_1\{\ \}$ signifie le filtrage par le filtre F1. On obtient ainsi une deuxième équation comprenant la tension d'entrée filtrée et la tension de sortie filtrée.

L'emploi du filtre F1 permet d'éviter la difficulté représentée par le calcul des dérivées temporelles directes des signaux d'entrée et de sortie $\dot{u}_s(t)$ et $\dot{u}_e(t)$. En effet, le calcul de ces dérivées est rendu difficile par la présence dans le cas réel, de bruit affectant les signaux $u_s(t)$ et $u_e(t)$.

Le procédé comprend également :

- une détermination (3B) de la tension d'entrée filtrée par le filtre F1, $F_1\{u_e(t)\}$ et de la tension d'entrée dérivée filtrée par le filtre F1, $F_1\{\dot{u}_e(t)\}$; et
- une détermination (3C) de la tension de sortie filtrée par le filtre F1, $F_1\{u_s(t)\}$ et de la tension de sortie dérivée filtrée par le filtre F1, $F_1\{\dot{u}_s(t)\}$.

Pour calculer les termes $F_1\{u_e(t)\}$, $F_1\{\dot{u}_e(t)\}$, $F_1\{u_s(t)\}$ et $F_1\{\dot{u}_s(t)\}$ et réaliser les deux étapes 3B et 3C, on utilise la tension de sortie Us mesurée, la tension d'entrée Ue de valeur connue et les équations suivantes :

$$\begin{cases} \dot{z}(t) = A\,z(t) + B\,x(t) \\ X(t) = C\,z(t) \end{cases} \qquad (Equation\ 3)$$

dans laquelle,

$$A = \begin{bmatrix} -\lambda & 0 \\ \lambda & -\lambda \end{bmatrix} ; B = \begin{bmatrix} \lambda \\ 0 \end{bmatrix} ; C = \begin{bmatrix} \lambda & -\lambda \\ 0 & 1 \end{bmatrix}$$

$$z(t) = \begin{bmatrix} F_0\{x(t)\} \\ F_1\{x(t)\} \end{bmatrix} ; X(t) = \begin{bmatrix} F_1\{\dot{x}(t)\} \\ F_1\{x(t)\} \end{bmatrix}$$

dans lesquelles x(t) est le signal Us(t) ou Ue(t).

Puis, le procédé comprend une étape 3D au cours de laquelle on détermine les paramètres de ladite deuxième équation.

Pour cela, étant donné que les termes $F_1\{u_s(t)\}$, $F_1\{\dot{u}_s(t)\}$, $F_1\{u_e(t)\}$ et $F_1\{\dot{u}_e(t)\}$ sont connus à partir des étapes 3B et 3C, on peut déduire, à partir par exemple d'une méthode dite des « moindres carrés », les paramètres $a_0$, $b_0$ et $b_1$ de l'équation 2, $F_1\{\dot{u}_s(t)\}$ = $-a_0\,F_1\{u_s(t)\} + b_0\,F_1\{u_e(t)\} + b_1\,F_1\{\dot{u}_e(t)\}$.

Pour réaliser la méthode des moindres carrés, on fait varier le paramètre temporel t de $t_1$ à $t_N$ dans l'équation 2. A titre d'exemple de réalisation on peut par exemple avec une période d'échantillonnage de 10 ms et un signal Ue(t) carré de 0,5 Hz prévoir une variation du paramètre temporel de manière à couvrir une période du signal Ue(t). On pourrait également faire varier le paramètre temporel sur un intervalle plus important pour obtenir une meilleure estimation des paramètres de l'équation 2.

Grâce à cette variation, la forme matricielle suivante peut alors être obtenue :

$$Y = \Gamma\,\Theta \qquad\qquad\qquad (\text{Equation } 4)$$

dans laquelle:

$$Y = \begin{bmatrix} F_1\{\dot{u}_s(t_1)\} \\ \vdots \\ F_1\{\dot{u}_s(t_N)\} \end{bmatrix} ;\; \Gamma = \begin{bmatrix} -F_1\{u_s(t_1)\} & F_1\{u_e(t_1)\} & F_1\{\dot{u}_e(t_1)\} \\ \vdots & \vdots & \vdots \\ -F_1\{u_s(t_N)\} & F_1\{u_e(t_N)\} & F_1\{\dot{u}_e(t_N)\} \end{bmatrix} ;\; \Theta = \begin{bmatrix} a_0 \\ b_0 \\ b_1 \end{bmatrix}$$

Le vecteur $\Theta$ des paramètres à déterminer peut donc être calculé tel que :

$$\Theta = \left(\Gamma^T\Gamma\right)^{-1}\Gamma^T Y \qquad\qquad\qquad (\text{Equation } 5),$$

dans laquelle «$^T$» désigne la transposée et «$^{-1}$» désigne l'opération d'inversion matricielle.

Enfin le procédé comprend une quatrième étape (étape 4) de détermination de la résistance d'isolement Risol et de la capacité CE à partir desdits paramètres. Pour cela on utilise le changement de variables de l'équation 1 :

$$\begin{cases} R_{isol} \cdot CE = \dfrac{b_1}{a_0} \\[2ex] CE \cdot \left(R_{isol} + R\right) = \dfrac{1}{a_0} \end{cases}$$

$$\begin{cases} R_{isol} = R \cdot \dfrac{b_1}{1 - b_1} \\[2ex] CE = \dfrac{1}{R} \cdot \dfrac{1 - b_1}{a_0} \end{cases}$$

La méthode de mesure présentée permet ainsi d'estimer la valeur de la résistance d'isolation Risol et du condensateur CM à l'issue d'une unique réalisation du procédé illustré.

Selon un autre exemple d'application, on pourrait également prévoir des méthodes d'identification itératives selon lesquelles on calcule la valeur de la résistance d'isolation Risol et du condensateur CE, puis on met à jour ces valeurs calculées grâce au procédé de mesure illustré réalisé à chaque itération.

Les étapes de calcul 3A, 3B, 3C, 3D et 4 sont par exemple mises en oeuvre par un ou plusieurs blocs de calcul intégrés dans une unité de traitement numérique. Les blocs de calculs mettant en oeuvre les étapes 3A, 3B, 3C, 3D et 4 peuvent être réalisés sous forme de modules logiciels ou bien pour certains d'entre eux sous forme de circuits logiques.

Pour la détermination de la résistance Risol et de la capacité CE, on peut, selon un deuxième mode de mise en oeuvre, mesurer l'impédance complexe Z en transmission du dipôle illustré sur la figure 1 comprenant la capacité CE en série avec la résistance Risol.

L'impédance complexe Z en transmission est reliée à la tension de sortie Us par l'équation d'impédance ci après :

$$\underline{Us} = Z \cdot \underline{i} \qquad\qquad\qquad (\text{Équation } 6)$$

dans laquelle,
$Us$ et $i$ sont respectivement la tension de sortie Us et une intensité i qui entre sur le dipôle en écriture exponentielle.

Pour mesurer l'impédance complexe Z, on utilise un analyseur de réseau.

L'analyseur de réseau est branché sur la borne d'entrée du circuit de mesure CM pour envoyer un signal d'entrée dont l'amplitude et la fréquence sont connues ayant une tension Ue. L'analyseur de réseau va également mesurer la tension de sortie Us aux bornes du dipôle. Pour cela, on utilise entre l'analyseur de réseau et le circuit de mesure, un convertisseur analogique numérique. Le convertisseur analogique numérique va échantillonner la tension Us qui sera alors transmise sous forme échantillonnée à l'analyseur de réseau.

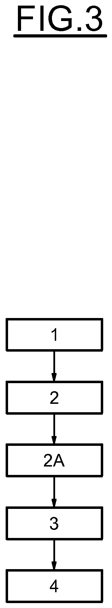

Sur la figure 3, est représenté selon le deuxième mode de mise en oeuvre, le procédé de mesure permettant de déterminer la valeur de la résistance d'isolement Risol et de la capacité CE du circuit de mesure CM à partir de la mesure de l'impédance complexe.

Ce procédé comprend :

- une application (étape 1) d'un signal d'entrée de tension Ue, à l'entrée du circuit de mesure. Cette application est réalisée par l'analyseur de réseau qui peut par exemple émettre une tension d'entrée Ue sur la borne d'entrée du circuit CM ;
- une mesure (étape 2) de la tension de sortie Us aux bornes du dipôle électrique comprenant la capacité CE du circuit de mesure CM et la résistance d'isolement Risol. Cette mesure est réalisée au moyen d'un convertisseur analogique numérique qui va numériser (étape 2A) la tension Us pour la transmettre sous forme échantillonnée à l'analyseur de réseau ;
- une détermination (étape 3) de l'impédance complexe Z du dipôle. L'étape de détermination comprend une analyse fréquentielle de la tension de sortie numérisée à au moins une fréquence *f* et le calcul de l'angle et du module de l'impédance complexe Z pour chacune des pulsations $\Omega$ correspondant aux fréquences *f* ($\Omega=2\pi f$ selon une formule bien connue de l'homme du métier). Cette détermination comprend en outre un calcul de la valeur de l'impédance complexe du dipôle pour chacune des pulsations $\Omega$ à partir du module et de l'angle de l'impédance Z, selon l'équation ci-dessous :

$$Z = R \cdot e^{i\theta},$$

dans laquelle R représente le module de l'impédance complexe Z et $\theta$ représente l'angle (ou phase) de l'impédance complexe Z.

L'étape de détermination est effectuée par l'analyseur de réseau.

Selon un mode de réalisation, l'analyse fréquentielle est réalisée sur un intervalle de fréquences (par exemple de 1 kHz à 5 kHz en fonction de la valeur nominale des composants R, Risol et CE) et comprend une transformée de Fourier rapide de type FFT (selon un acronyme anglo-saxon bien connu de l'homme du métier signifiant Fast Fourier Transform) de la tension de sortie numérisée.

Selon un autre mode de réalisation l'analyse fréquentielle peut être réalisée au moyen d'un filtrage de Goertzel. Le filtrage de Goertzel est plus rapide puisque contrairement à la transformée de Fourier, il ne nécessite pas de calculer l'ensemble du spectre mais se limite au calcul d'une raie de spectre de la transformée de Fourier échantillonnée.

On peut selon ces deux modes de réalisation utiliser comme signal d'entrée un signal carré, on connait l'amplitude relative des différentes composantes fréquentielles. Plus précisément avec un signal carré prenant les valeurs +1 ou -1, l'amplitude de la composante du signal carré est $4/\pi$ à la fréquence fondamentale, l'amplitude de l'harmonique 3 est $4/(3\cdot\pi)$ et l'amplitude de l'harmonique 5 est $4/(5\cdot\pi)$.

Dans le cas du filtrage de Goertzel, on peut réaliser l'analyse fréquentielle uniquement sur les raies de spectres correspondantes à la fréquence fondamentale, l'harmonique 3 et l'harmonique 5 du signal d'entrée de tension Ue.

Dans le cas de la transformée de Fourier, on peut réaliser l'analyse d'une partie du spectre du signal de tension Ue comprenant ces fréquences.

Dans le cas du filtrage de Goertzel ou de la transformée de Fourier, on déduit pour chacune des raies de la fréquence fondamentale de l'harmonique 3 et de l'harmonique 5, le module de l'impédance complexe et la phase de l'impédance complexe à partir respectivement du rapport des amplitudes de la tension de sortie et du signal d'entrée, et du déphasage entre la tension de sortie et le signal d'entrée. On peut alors calculer l'impédance complexe pour les pulsations correspondant à chacune de ces raies.

Selon un mode de réalisation, la fréquence du signal d'entrée correspondante à ladite fréquence fondamentale sera choisie de manière à minimiser le rapport signal sur bruit du spectre de la tension de sortie. Cela est possible par exemple en évitant les fréquences liées à une électronique de puissance telle qu'un onduleur par exemple dans une autre partie de l'électronique du véhicule ou en évitant les problèmes liés au repliement de spectre des signaux de l'électronique de puissance.

La fréquence du signal d'entrée peut également être choisie en fonction de la valeur nominale des composants R, Risol et CE. Ou encore, la fréquence du signal d'entrée peut être choisie de manière que la capacité CE à utiliser soit faible. En effet, plus la capacité est élevée, plus elle coûte chère en général.

Le procédé comprend en outre :

- une détermination (étape 4) de la valeur de la résistance d'isolement Risol et de la capacité CE du circuit de mesure CM à partir de l'impédance pour au moins une fréquence considérée. Pour cela, on utilise l'équation ci-dessous :

$$Z = Z1 + i \cdot Z2 = R \cdot e^{i\theta}$$
$$Risol = -\left(\left(Z1^2 - Z1 + Z2^2\right) \cdot R\right)/\left(Z1^2 - 2 \times Z1 + Z2^2 + 1\right) \qquad (\text{Équation 7}),$$
$$CE = \left(Z1^2 - 2 \times Z1 + Z2^2 + 1\right)/(\Omega \cdot Z2 \cdot R)$$

dans laquelle Z1 et Z2 représentent respectivement la partie réelle et la partie imaginaire de l'impédance complexe Z et $\Omega$ représente la pulsation pour laquelle on a déterminé l'impédance complexe.

L'étape de calcul 4 est par exemple mise en oeuvre par un bloc de calcul intégré dans une unité de traitement numérique de l'analyseur de réseau. Le bloc de calcul mettant en oeuvre l'étape 4 peut être réalisé sous forme de modules logiciels ou bien sous forme de circuits logiques.

On peut, par exemple, dans le cas où l'on a évalué les impédances complexes pour plusieurs fréquences, déduire de chacune des impédances complexes une valeur de la résistance d'isolement Risol. On peut alors comparer les différentes résistances d'isolement pour contrôler la pertinence de la mesure.

Par ailleurs, la mesure de la capacité CE permet, dans le cas où le circuit de mesure est constamment monté sur la borne de la batterie Batt, de détecter si la valeur de la capacité CE s'écarte de sa valeur nominale, un vieillissement de la capacité. Ce qui permet dans le cas par exemple d'un vieillissement anormal d'obtenir une fonction de diagnostic embarqué de l'électronique du véhicule.

Selon un exemple d'application des deux modes de réalisation illustré sur la figure 2 ou 3, ce qui importe plus particulièrement est de détecter un dysfonctionnement. Une estimation permettant de déterminer que la valeur de la résistance d'isolation est inférieure à une certaine valeur, peut alors être suffisante pour détecter un défaut d'isolation. Cela permet ainsi de réduire les contraintes de précision sur la mesure (réduire l'intervalle de mesure, réduire la précision de la résistance R ou du signal Ue) et donc de réduire le coût de la solution d'estimation ou de la rendre plus rapide. Par exemple, dans le cas d'une batterie de 400 volts, il est suffisant de déterminer que la résistance d'isolation a une valeur inférieure à 1 MegaOhms.

## Revendications

1. Procédé d'estimation de la résistance d'isolement entre une borne d'une batterie (Batt) et une masse électrique, comprenant :

   - un branchement d'une borne de sortie d'un circuit de mesure (CM) à une borne de la batterie (Batt), ledit circuit de mesure comprenant une résistance de valeur connue (R) et une capacité (CE) ; et
   - une application (1) d'un signal d'entrée connu ayant une tension d'entrée (Ue) à une borne d'entrée du circuit de mesure (CM),

   **caractérisé en ce que** le procédé comprend en outre :

   - une mesure (2) d'une tension de sortie entre la masse et un point (P) situé entre la résistance de valeur connue (R) et la capacité (CE) ;
   - une détermination (3) d'une impédance complexe d'un dipôle composé de la capacité (CE) et de la résistance d'isolement (Risol) ou une détermination des paramètres d'une équation différentielle reliant la tension de sortie et la tension d'entrée ; et
   - une détermination (4) de la résistance d'isolement (Risol) à partir des paramètres de l'équation différentielle ou de ladite impédance complexe.

2. Procédé selon la revendication 1, comprenant en outre une détermination de la capacité (CE) du circuit de mesure à partir des paramètres de l'équation différentielle ou de ladite impédance complexe.

3. Procédé selon l'une des revendications 1 ou 2, dans lequel le signal d'entrée appliqué est un signal carré.

4. Procédé selon l'une des revendications 1 à 3, dans lequel la détermination (3) des paramètres de l'équation différentielle comprend:

- un filtrage (3A) par un filtre linéaire de premier ordre de l'équation différentielle pour obtenir une deuxième équation reliant la tension d'entrée filtrée et la tension de sortie filtrée ;
- une détermination (3B) à partir de la tension d'entrée, de la tension d'entrée filtrée ;
- une détermination (3C) à partir de la tension de sortie, de la tension de sortie filtrée ; et
- une détermination (3D) des paramètres de ladite deuxième équation, lesdits paramètres de la deuxième équation étant égaux aux paramètres de l'équation différentielle.

5. Procédé selon la revendication 4, dans lequel ladite mesure de la tension de sortie (2) est réalisée à plusieurs instants et la détermination (3) des paramètres de ladite deuxième équation utilise une méthode des moindres carrés avec les valeurs auxdits plusieurs instants de la tension de sortie mesurée et de la tension d'entrée.

6. Procédé selon l'une des revendications 1 à 3, comprenant en outre une analyse fréquentielle de la tension de sortie mesurée à au moins une fréquence de manière à déterminer (3) pour au moins cette fréquence, la valeur de l'impédance complexe, ladite application (1) d'un signal d'entrée à la borne d'entrée du circuit de mesure, ladite mesure (2) de la tension de sortie, ladite analyse fréquentielle et ladite détermination (3) de la valeur de l'impédance complexe étant réalisées par un analyseur de réseau.

7. Procédé selon la revendication 6, dans lequel le procédé comprend en outre une numérisation (2A) de la tension de sortie mesurée et l'analyse fréquentielle est réalisée au moyen d'une transformée de Fourier ou d'un filtrage de Goertzel de la tension de sortie numérisée.

8. Procédé selon la revendication 7, dans lequel l'analyse fréquentielle est effectuée à une fréquence fondamentale de la tension d'entrée et/ou à deux harmoniques de la tension d'entrée.

9. Système d'estimation de la résistance d'isolement entre une borne d'une batterie et une masse électrique, comprenant un circuit de mesure qui comprend une borne de sortie, une borne d'entrée, une résistance de valeur connue (R) et une capacité (CE), la borne de sortie étant branchée à une borne de la batterie (Batt) et la borne d'entrée étant destinée à recevoir un signal d'entrée connu ayant une tension d'entrée (Ue),
**caractérisé en ce que** le système comprend en outre :

- un moyen de mesure (2) d'une tension de sortie entre la masse et un point (P) situé entre la résistance de valeur connue (R) et la capacité (CE);
- un moyen de détermination (3) d'une impédance complexe d'un dipôle composé de la capacité (CE) et de la résistance d'isolement (Risol) ou de paramètres d'une équation différentielle reliant la tension de sortie et la tension d'entrée; et
- un moyen de détermination (4) de la résistance d'isolement à partir des paramètres de l'équation différentielle ou de ladite impédance complexe.

## Patentansprüche

1. Verfahren zur Abschätzung des Isolationswiderstands zwischen einem Anschluss einer Batterie (Batt) und einer elektrischen Masse, umfassend:

- das Verbinden eines Ausgangsanschlusses einer Messschaltung (CM) mit einem Anschluss der Batterie (Batt), wobei die Messschaltung einen Widerstand (R) mit bekanntem Wert und eine Kapazität (CE) umfasst; und
- das Anlegen (1) eines bekannten Eingangssignals mit einer Eingangsspannung (Ue) an einen Eingangsanschluss der Messschaltung (CM), **dadurch gekennzeichnet, dass** das Verfahren darüber hinaus Folgendes umfasst:
- das Messen (2) einer Ausgangsspannung zwischen der Masse und einem Punkt (P), der sich zwischen dem Widerstand (R) mit bekanntem Wert und der Kapazität (CE) befindet;
- das Bestimmen (3) einer komplexen Impedanz eines Dipols, der sich aus der Kapazität (CE) und dem Isolationswiderstand (Risol) zusammensetzt, oder das Bestimmen der Parameter einer Differenzialgleichung, die die Ausgangsspannung und die Eingangsspannung miteinander verknüpft; und
- das Bestimmen (4) des Isolationswiderstands (Risol) aus den Parametern der Differenzialgleichung oder der komplexen Impedanz.

**2.** Verfahren nach Anspruch 1, das darüber hinaus das Bestimmen der Kapazität (CE) der Messschaltung aus den Parametern der Differenzialgleichung oder der komplexen Impedanz umfasst.

**3.** Verfahren nach einem der Ansprüche 1 oder 2, bei dem das angelegte Eingangssignal ein Rechtecksignal ist.

**4.** Verfahren nach einem der Ansprüche 1 bis 3, wobei das Bestimmen (3) der Parameter der Differenzialgleichung umfasst:

- das Filtern (3A) der Differenzialgleichung durch einen linearen Filter erster Ordnung, um eine zweite Gleichung zu erhalten, die die gefilterte Eingangsspannung und die gefilterte Ausgangsspannung miteinander verknüpft;
- das Bestimmen (3B) der gefilterten Eingangsspannung ausgehend von der Eingangsspannung;
- das Bestimmen (3C) der gefilterten Ausgangsspannung ausgehend von der Ausgangsspannung; und
- das Bestimmen (3D) der Parameter der zweiten Gleichung, wobei die Parameter der zweiten Gleichung gleich den Parametern der Differenzialgleichung sind.

**5.** Verfahren nach Anspruch 4, bei dem das Messen der Ausgangsspannung (2) zu mehreren Zeitpunkten durchgeführt wird und das Bestimmen (3) der Parameter der zweiten Gleichung ein Verfahren der kleinsten Quadrate mit den Werten zu den mehreren Zeitpunkten der gemessenen Ausgangsspannung und der Eingangsspannung verwendet.

**6.** Verfahren nach einem der Ansprüche 1 bis 3, das darüber hinaus eine Frequenzanalyse der Ausgangsspannung umfasst, die bei mindestens einer Frequenz gemessenen wird, um für mindestens diese Frequenz den Wert der komplexen Impedanz zu bestimmen (3), wobei das Anlegen (1) eines Eingangssignals an den Eingangsanschluss der Messschaltung, das Messen (2) der Ausgangsspannung, die Frequenzanalyse und das Bestimmen (3) des Wertes der komplexen Impedanz von einem Netzwerkanalysator durchgeführt werden.

**7.** Verfahren nach Anspruch 6, wobei das Verfahren darüber hinaus das Digitalisieren (2A) der gemessenen Ausgangsspannung und die Frequenzanalyse umfasst, die unter Verwendung einer Fourier-Transformation oder einer Goertzel-Filterung der digitalisierten Ausgangsspannung durchgeführt wird.

**8.** Verfahren nach Anspruch 7, wobei die Frequenzanalyse bei einer Grundfrequenz der Eingangsspannung und/oder bei zwei Oberschwingungen der Eingangsspannung durchgeführt wird.

**9.** System zur Abschätzung des Isolationswiderstands zwischen einem Anschluss einer Batterie und einer elektrischen Masse, umfassend eine Messschaltung, die einen Ausgangsanschluss, einen Eingangsanschluss, einen Widerstand (R) mit bekanntem Wert und eine Kapazität (CE) umfasst, wobei der Ausgangsanschluss mit einem Anschluss der Batterie (Batt) verbunden ist und der Eingangsanschluss zum Empfangen eines bekannten Eingangssignals mit einer Eingangsspannung (Ue) dient, **dadurch gekennzeichnet, dass** das System darüber hinaus Folgendes enthält:

- eine Vorrichtung zum Messen (2) einer Ausgangsspannung zwischen der Masse und einem Punkt (P), der sich zwischen dem Widerstand (R) mit bekanntem Wert und der Kapazität (CE) befindet;
- eine Vorrichtung zum Bestimmen (3) einer komplexen Impedanz eines Dipols, der sich aus der Kapazität (CE) und dem Isolationswiderstand (Risol) zusammensetzt, oder von Parametern einer Differenzialgleichung, die die Ausgangsspannung und die Eingangsspannung miteinander verknüpft; und
- eine Vorrichtung zum Bestimmen (4) des Isolationswiderstands aus den Parametern der Differenzialgleichung oder der komplexen Impedanz.

**Claims**

**1.** Method for estimating the insulation resistance between a terminal of a battery (Batt) and an electrical ground, comprising:

- connecting an output terminal of a measurement circuit (CM) to a terminal of the battery (Batt), said measurement circuit comprising a resistor of known value (R) and a capacitor (CE); and
- applying (1) a known input signal having an input voltage (Ue) to an input terminal of the measurement circuit (CM),

**characterized in that** the method furthermore comprises:

- measuring (2) an output voltage between the ground and a point (P) situated between the resistor of known value (R) and the capacitor (CE);
- determining (3) a complex impedance of a dipole formed of the capacitor (CE) and of the insulation resistance (Risol) or determining the parameters of a differential equation linking the output voltage and the input voltage; and
- determining (4) the insulation resistance (Risol) from the parameters of the differential equation or from said complex impedance.

2. Method according to Claim 1, furthermore comprising determining the capacitance (CE) of the measurement circuit from the parameters of the differential equation or from said complex impedance.

3. Method according to either of Claims 1 and 2, wherein the applied input signal is a square-wave signal.

4. Method according to one of Claims 1 to 3, wherein determining (3) the parameters of the differential equation comprises:

- filtering (3A), by way of a first-order linear filter, the differential equation so as to obtain a second equation linking the filtered input voltage and the filtered output voltage;
- determining (3B) the filtered input voltage from the input voltage;
- determining (3C) the filtered output voltage from the output voltage; and
- determining (3D) the parameters of said second equation, said parameters of the second equation being equal to the parameters of the differential equation.

5. Method according to Claim 4, wherein said output voltage measurement (2) is performed at several instants and the determination (3) of the parameters of said second equation uses a least-squares method with the values, at said several instants, of the measured output voltage and of the input voltage.

6. Method according to one of Claims 1 to 3, furthermore comprising frequency analysis of the measured output voltage at at least one frequency, so as to determine (3), for at least this frequency, the value of the complex impedance, said application (1) of an input signal to the input terminal of the measurement circuit, said measurement (2) of the output voltage, said frequency analysis and said determination (3) of the value of the complex impedance being performed by a network analyser.

7. Method according to Claim 6, wherein the method furthermore comprises digitizing (2A) the measured output voltage, and the frequency analysis is performed by way of a Fourier transform or of Goertzel filtering of the digitized output voltage.

8. Method according to Claim 7, wherein the frequency analysis is performed at a fundamental frequency of the input voltage and/or at two harmonics of the input voltage.

9. System for estimating the insulation resistance between a terminal of a battery and an electrical ground, comprising a measurement circuit that comprises an output terminal, an input terminal, a resistor of known value (R) and a capacitor (CE), the output terminal being connected to a terminal of the battery (Batt) and the input terminal being intended to receive a known input signal having an input voltage (Ue), **characterized in that** the system furthermore comprises:

- a means for measuring (2) an output voltage between the ground and a point (P) situated between the resistor of known value (R) and the capacitor (CE);
- a means for determining (3) a complex impedance of a dipole formed of the capacitor (CE) and of the insulation resistance (Risol) or parameters of a differential equation linking the output voltage and the input voltage; and
- a means for determining (4) the insulation resistance from the parameters of the differential equation or from said complex impedance.

## FIG.1

## FIG.2

# FIG.3

```
┌─────────────┐
│      1      │
└─────────────┘
       │
       ▼
┌─────────────┐
│      2      │
└─────────────┘
       │
       ▼
┌─────────────┐
│     2A      │
└─────────────┘
       │
       ▼
┌─────────────┐
│      3      │
└─────────────┘
       │
       ▼
┌─────────────┐
│      4      │
└─────────────┘
```

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2003250201 A
- US 2004130326 A